(19) Europäisches Patentamt
European Patent Office
Office européen des brevets

(11) **EP 3 650 876 B1**

(12) **FASCICULE DE BREVET EUROPEEN**

(45) Date de publication et mention de la délivrance du brevet:
**12.05.2021 Bulletin 2021/19**

(51) Int Cl.:
***G01R 31/34*** *(2020.01)*

(21) Numéro de dépôt: **19207934.1**

(22) Date de dépôt: **08.11.2019**

(54) **DÉTECTION DE DÉFAUT ÉLECTRIQUE DANS UNE GÉNÉRATRICE**

DETEKTION EINER ELEKTRISCHEN STÖRUNG IN EINEM GENERATOR

DETECTION OF ELECTRICAL FAULT IN A GENERATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.11.2018 FR 1871481**

(43) Date de publication de la demande:
**13.05.2020 Bulletin 2020/20**

(73) Titulaire: **Electricité de France**
**75008 Paris (FR)**

(72) Inventeurs:
• **CHEAYTANI, Jalal**
**75014 PARIS (FR)**
• **LANGLET, Jeremy**
**92410 VILLE D'AVRAY (FR)**
• **COSTAN, Valentin**
**92340 BOURG LA REINE (FR)**

(74) Mandataire: **Plasseraud IP**
**66, rue de la Chaussée d'Antin**
**75440 Paris Cedex 09 (FR)**

(56) Documents cités:
**CN-A- 106 597 276     CN-A- 106 841 900**
**PL-B1- 220 252**

**Description**

**Domaine technique**

L'invention relève du domaine des machines électriques tournantes, typiquement les génératrices, et en particulier les machines asynchrones à double alimentation, ou « MADA ».

**Technique antérieure**

Il est connu d'effectuer des surveillances des MADA par l'intermédiaire de mesures électriques, afin de détecter d'éventuels défauts. Les MADA étant un composant essentiel dans les éoliennes, de telles surveillances trouvent en particulier à s'appliquer dans le contexte des surveillances et maintenances préventives des éoliennes. Les mesures électriques sont peu couteuses, non intrusives, peuvent être réalisées à distance, sensiblement en temps réel et de manière automatisée. Ainsi, de telles surveillances permettent de planifier des opérations préventives lorsque des défauts mineurs sont détectés précocement, avant que de tels défauts s'aggravent et entrainent des dégradations importantes et couteuses à réparer.

Parmi les méthodes de surveillance connues, beaucoup doivent être mises en œuvre alors que les MADA sont à l'arrêt, ce qui implique d'interrompre leur fonctionnement usuel, et donc la production d'énergie dans le cas des éoliennes.

Dans le contexte des éoliennes, d'autres méthodes connues sont basées sur des analyses vibratoires. Les analyses vibratoires sont mises en œuvre au cours du fonctionnement (sans interrompre la production d'énergie) et permettent de détecter de nombreuses anomalies dans la chaîne cinématique des éoliennes. Néanmoins, les analyses vibratoires sont peu fiables pour détecter des anomalies résultant de défauts dans les MADA. Lorsqu'une anomalie dont la cause se situe dans la MADA est détectée par analyse vibratoire, cela signifie souvent que le défaut est grave et que des mesures d'urgence doivent être mises en œuvre. Une opération de maintenance légère n'est pas, ou plus, suffisante.

Enfin, il existe des méthodes de surveillance et de détection de défauts basées sur des mesures électriques. Lesdites méthodes impliquent généralement une analyse harmonique par transformées de Fourrier de courants électriques mesurés. Ensuite, des fréquences caractéristiques de chaque type de défaut connu sont recherchées. Par nature, cela interdit une surveillance fine de variations dans le temps car les mesures sont moyennées sur le temps. En outre, de telles méthodes sont efficaces seulement à fréquence constante, ce qui n'est pas le cas, en pratique, dans une MADA. Les variations de fréquences sont particulièrement importantes dans les MADA d'éoliennes car les fréquences dépendent de la vitesse du vent, elle-même variable au cours du temps. Enfin, la demanderesse a constaté que les fréquences caractéristiques des défauts les plus communs sont proches, en fréquence, de la fréquence fondamentale des MADA, au point d'être difficile à distinguer les unes de l'autre. Cela rend d'autant plus complexe et peu fiable de telles méthodes de surveillances, au moins pour certains défauts des MADA. Il existe des risques élevés de ne pas détecter une anomalie réelle et d'identifier une anomalie fictive (« faux positif »).

Des documents pertinents pour l'état de la technique sont CN 106 841 900, PL 220 252 et CN 106 597 276.

**Résumé de l'invention**

L'invention vient améliorer la situation.

Il est proposé un procédé de surveillance et détection de défaut dans une machine asynchrone à double alimentation incluant un stator et un rotor. Le procédé est mis en œuvre par des moyens informatiques. Le procédé comprend :

a. recevoir, en entrée et en fonction du temps, une mesure de courant et une mesure de tension d'au moins une phase du stator, et une mesure de vitesse de rotation relative entre le stator et le rotor ;
b. déduire des mesures de courant et de tension reçues une puissance statorique en fonction du temps ;
c. effectuer une analyse harmonique de la puissance statorique obtenue, ladite analyse harmonique incluant d'appliquer une transformée en ondelettes à la puissance statorique obtenue, de sorte qu'une représentation harmonique de la puissance statorique, en fonction de la fréquence, est obtenue ;
d. comparer la représentation harmonique obtenue à une représentation harmonique de référence, ladite représentation harmonique de référence étant sélectionnée en fonction de la mesure de vitesse de rotation, de manière à détecter des défauts dans ladite machine en fonction d'éventuelles différences identifiées par la comparaison. Ensuite, un signal d'alerte peut être généré et transmis de sorte qu'une opération de maintenance ou réparation soit planifiée.

Il est aussi proposé un système de surveillance d'au moins une machine asynchrone à double alimentation comprenant au moins un capteur de tension, un capteur de courant, un capteur de vitesse de rotation et un module de calcul, chaque capteur étant agencé pour transmettre des données de mesure à l'au moins un module de calcul, ledit module de calcul étant agencé pour mettre en œuvre un procédé tel que décrit dans les présentes. Il est aussi proposé un programme informatique comportant des instructions pour la mise en œuvre d'un procédé tel que défini dans les présentes lorsque ce programme est exécuté par un processeur. Il est aussi proposé un support d'enregistrement non transitoire, lisible par un ordinateur, sur lequel est enregistré un tel programme.

Les caractéristiques exposées dans les paragraphes suivants peuvent, option-nellement, être mises en œuvre. Elles peuvent être mises en œuvre indépendamment les unes des autres ou en combinaison les unes avec les autres :

Dans le procédé, la représentation harmonique de référence peut être sélectionnée en fonction, en outre, d'une puissance réactive de la machine et d'une tension statorique.

Dans le procédé, les mesures peuvent être effectuées sur des durées comprises 1 et 5 secondes et/ou avec une fréquence d'échantillonnage comprise entre 5 et 20 kilohertz.

Le procédé peut comprendre en outre, préalablement à l'analyse harmonique de la puissance statorique, une opération de détermination d'au moins une fréquence d'un défaut connu en fonction de la vitesse de rotation, l'analyse harmonique étant ensuite mise en œuvre pour chacune des fréquences de défaut déterminées.

Le procédé peut comprendre en outre, après déduction de la puissance statorique et préalablement à l'analyse harmonique de la puissance statorique, une opération de vérification de stabilité des puissances au cours de la durée de prise de mesure.

Le procédé peut être répété de sorte qu'une surveillance en temps réel de la machine asynchrone à double alimentation est menée.

**Brève description des dessins**

D'autres caractéristiques, détails et avantages de l'invention apparaîtront à la lecture de la description détaillée ci-après, et à l'analyse des dessins annexés, sur lesquels :

**Fig. 1**

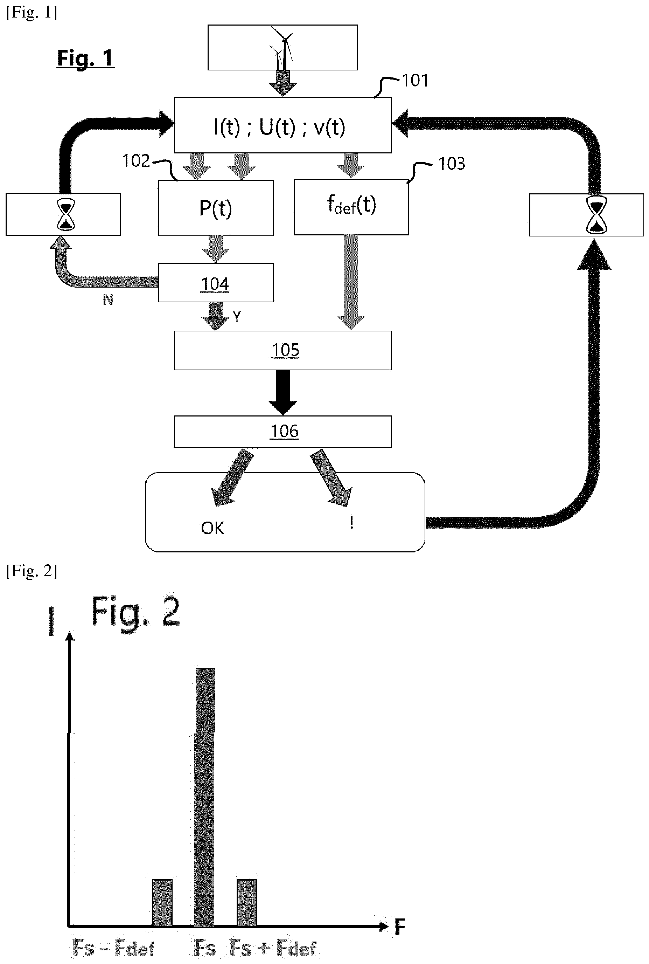

[fig.1] montre un procédé selon un mode de réalisation de l'invention ;
**Fig. 2**
[fig.2] montre une représentation harmonique des courants électriques en présence d'un défaut ;
**Fig. 3**

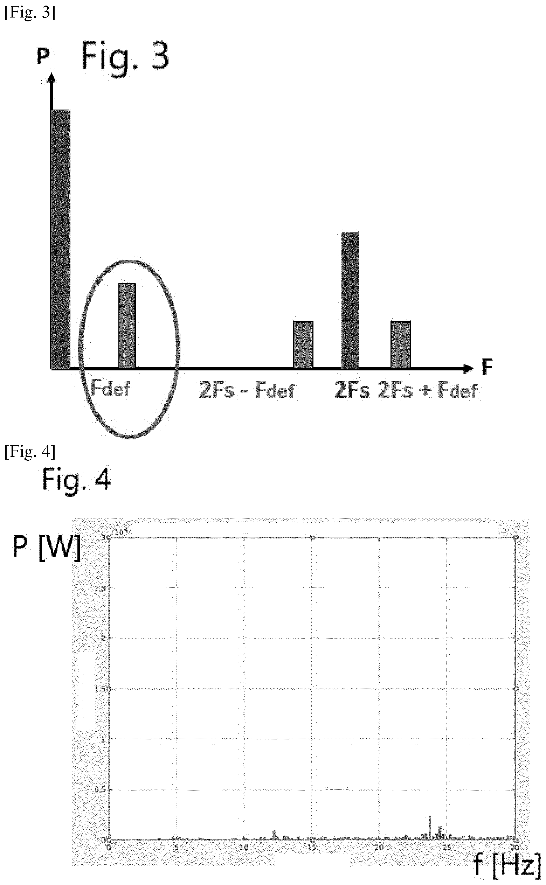

[fig.3] montre une représentation harmonique des puissances électriques en présence d'un défaut obtenue par un mode de réalisation de l'invention ;
**Fig. 4**
[fig.4] montre une représentation harmonique de la puissance statorique totale d'une génératrice sans défaut ;
**Fig. 5**

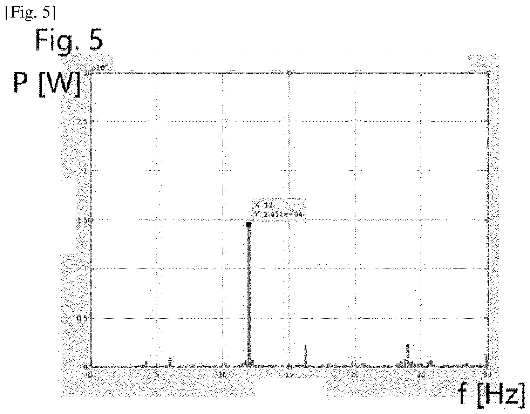

[fig.5] montre une représentation harmonique de la puissance statorique totale de la même génératrice qu'en [Fig. 4] mais avec un défaut.

**Description des modes de réalisation**

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

Il est maintenant fait référence à la figure 1. Un procédé de surveillance et détection de défaut dans une machine asynchrone à double alimentation (MADA) y est représenté. La MADA inclut un stator et un rotor. Le procédé est mis en œuvre par des moyens informatiques. Le procédé comprend les opérations suivantes :

a. recevoir 101, en entrée et en fonction du temps, une mesure de courant I(t) et une mesure de tension U(t) d'au moins une phase du stator, et une mesure de vitesse de rotation v(t) relative entre le stator et le rotor ;
b. déduire 102 des mesures de courant I(t) et de tension U(t) reçues une puissance statorique P(t) en fonction du temps ;
c. effectuer 105 une analyse harmonique de la puissance statorique P(t) obtenue, ladite analyse harmonique incluant d'appliquer une transformée en ondelettes à la puissance statorique P(t) obtenue, de sorte qu'une représentation P(t,f) harmonique de la puissance statorique, en fonction de la fréquence, est obtenue ;
d. comparer (106) la représentation harmonique obtenue à une représentation harmonique de référence, ladite représentation harmonique de référence étant sélectionnée en fonction de la mesure de vitesse de rotation v(t), de manière à détecter des défauts dans ladite machine en fonction d'éventuelles différences identifiées par la comparaison.

Dans l'exemple décrit ici, chaque MADA appartient à une éolienne. Les MADA fonctionnent, ici, en courant triphasé. Les mesures de courant et de tension (opération a) sont effectuées distinctement sur chaque phase. Ainsi, lors de la détermination ultérieure de la puissance (opération b), la puissance déduite peut être la somme des trois puissances sur les trois phases. En cas d'anomalie, le cumul sur les trois phases permet d'amplifier les différences avec une MADA de référence considérée comme dépourvue de défaut. En variante, l'analyse peut être effectuée sur une seule phase ou sur seulement certaines d'entre elles. Dans la suite, et par souci de simplification, il est fait référence à une unique phase.

Les mesures sont effectuées préférentiellement sur le stator. L'installation de capteurs sur le stator est plus aisée que sur le rotor. En outre, les signaux électriques côté stator reproduisent d'une manière plus fiable l'état de la MADA. En effet, les courants circulant dans les enroulements statoriques dépendent de l'alimentation électrique et de l'impédance des enroulements, mais aussi des courants induits par le champ magnétique créé par le rotor. Ainsi, relever les tensions et courants sur les enroulements statoriques (plutôt que sur les enroulements rotoriques) permet ensuite de détecter tous les défauts, que ces derniers proviennent du stator ou du rotor.

Dans les exemples décrits, les mesures sont effectuées sur quelques secondes, par exemple entre 1 et 5 secondes. La fréquence d'échantillonnage est de quelques kilohertz, par exemple entre 5 et 20 kilohertz.

La déduction d'une puissance statorique P(t) en fonction du temps (opération b) peut prendre différentes formes. Elle peut résulter du simple produit du courant par la tension (P(t) = U(t).I(t)) d'une unique phase ou bien, par exemple, de la somme des produits tension par courant de chaque phase (P(t) = $U_1$(t).$I_1$(t) + $U_2$(t).$I_2$(t) + $U_3$(t).$I_3$ (t)), le chiffre en indice identifiant les phases les unes par rapport aux autres.

Ensuite, une analyse harmonique de la puissance statorique (P(t)) est effectuée. Pour comprendre en quoi consiste l'analyse harmonique, il est important de comprendre que, dans le cas d'une machine idéale (MADA théorique sans défaut ; indice « OK »), la puissance instantanée peut être exprimée selon l'équation suivante :

[Math.1]

$$P_{A\_OK}(t) = U_{AB}(t).I_{A\_OK}(t) = \frac{V_m.I_m}{2} cos\ \left(2\left(2\pi f_S.t\right) - \phi\right) + \frac{V_m.I_m}{2} cos\ (\phi)$$

Avec
[Math. 2]

[Math.Avec[Math. 2]]

$$U_{AB}(t) = V_m.cos\ \left(2\pi f_s.t\right)$$

[Math.3]

$$I_{A\_OK}(t) = I_m.cos\ \left(2\pi f_s.t - \phi\right)$$

$f_s$ représentant la fréquence d'alimentation électrique au stator et $\varphi$ représentant l'angle de déphasage entre le courant et la tension.

À partir de [Math. 1], il est possible d'observer que, lorsque la tension et le courant comportent une unique et même fréquence $f_s$, la puissance instantanée se décompose en somme d'une composante continue et d'une composante alternative à la fréquence 2.fs.

En présence d'un défaut, l'expression temporelle du courant statorique peut être définie à partir de l'équation générale de la modulation d'amplitude y(t) = (A+n(t)).c(t), où (A+ n(t)) est la fonction modulante et c(t) la fonction modulée. Dans ce cas, l'expression du courant au stator en présence d'un défaut (indice « def ») est la suivante :

[Math.4]

$$I_{A\_def}(t) = I_{A\_OK}(t).\left[1 + M.cos\ \left(2\pi f_{def}.t\right)\right]$$

[Math.5]

$$I_{A\_def}(t) = I_{A\_OK}(t) + \frac{M.I_m}{2}\cos\left(2\pi\left(f_s - f_{def}\right).t - \phi\right) + \frac{M.I_m}{2}\cos\left(2\pi\left(f_s + f_{def}\right).t - \phi\right)$$

L'équation [Math. 5] fait apparaître l'origine des deux raies caractéristiques du défaut : $(f_s - f_{def})$ et $(f_s + f_{def})$ et qui sont proches de la fréquence fondamentale $f_s$. De plus, l'expression de la puissance électrique en présence du défaut peut être :

[Math.6]

$$P_{A\_def}(t) = P_{A\_OK}(t) + \frac{M.V_m.I_m}{4}\cos\left(2\pi\left(2f_s - f_{def}\right).t - \phi\right) + \frac{M.V_m.I_m}{4}\cos\left(2\pi\left(2f_s + f_{def}\right).t - \phi\right) + \frac{M.V_m.I_m}{2}.\cos\left(\phi\right).\cos\left(f_{def}.t\right)$$

Cette expression de la puissance montre la présence de raies autour de la fréquence $2*f_s$ : $(2f_s - f_{def})$ et $(2f_s + f_{def})$. Cette expression montre en outre la présence de la fréquence du défaut isolée ($f_{def}$). La fréquence caractéristique du défaut dans la représentation harmonique de la puissance électrique permet ensuite le diagnostic et la détection des défauts dans la génératrice. Par exemple, pour un défaut rotorique dans les MADA, l'expression de la fréquence du défaut est $(2.g.f_s)$, avec « g » le glissement de la machine qui rend compte de l'écart de vitesse de rotation du rotor par rapport à la vitesse de rotation du champ statorique. Ainsi, les fréquences de défauts dans les MADA dépendent de la vitesse de rotation de la génératrice.

Les figures 2 et 3 montrent une comparaison entre la représentation harmonique des courants ([Fig. 2]) et des puissances ([Fig. 3]) électriques en présence du défaut.

Dans l'exemple décrit ici, une opération 103 est mise en œuvre. L'opération 103 comprend la détermination d'au moins une fréquence $f_{def}(t)$ d'un défaut connu en fonction de la vitesse de rotation $v(t)$. Connaitre à l'avance chaque fréquence de défaut connu permet de faciliter, ensuite, l'analyse harmonique pour chacun d'entre eux à partir de mesures réelles.

Dans l'exemple décrit ici, une opération 104, optionnelle, est mise en œuvre. L'opération 104 est mise en œuvre après calculs des puissances et avant mise en œuvre de l'analyse harmonique. Au cours de l'opération 104, les puissances calculées en fonction du temps sont soumises à un test de stabilité. Autrement dit, il est vérifié que les puissances calculées à partir des mesures de tensions et courants sont stables au cours de la durée de prise de mesure (généralement quelques secondes). Il est ainsi vérifié que la MADA n'est pas dans un état transitoire, typiquement le démarrage ou l'arrêt. La suite du procédé (analyse harmonique) est mise en œuvre seulement si des critères de stabilité préétablis sont remplis. Dans le cas contraire, une temporisation est mise en œuvre, par exemple comprise entre 1 et 10 minutes, puis le procédé est réinitialisé, de nouvelles mesures sont effectuées. Le choix des critères de stabilité dépend des dimensions de la MADA. Par exemple, le critère de stabilité peut consister à vérifier que la puissance reste supérieure à une valeur seuil pendant toute la durée de la mesure.

L'analyse harmonique de la puissance statorique P(t) obtenue inclut une transformée en ondelettes. En effet, les défauts à détecter dans les MADA sont caractérisés, dans la puissance électrique statorique, par des raies de fréquences dont la fréquence dépend de la vitesse de rotation de la machine, elle-même variable au cours du temps. Ainsi, contrairement à une transformée de Fourrier, une transformée d'ondelettes permet de tenir compte de la variation des fréquences et des amplitudes des raies de défauts sur la durée du signal. En conséquence, la fenêtre de temps (la durée de mesure) peut être très brève, en particulier plus courte que la durée de mesure nécessaire lorsque des analyses basées sur des transformées de Fourier sont mises en œuvre. L'analyse en ondelettes permet d'obtenir une représentation en fonction du temps et de la fréquence d'un signal. La représentation temps-fréquence met en jeu deux démarches réciproques : l'analyse et la synthèse. Pour effectuer l'analyse d'un signal, on le décompose en somme de constituants simples et universels appelés fonctions élémentaires. Les fonctions élémentaires d'une analyse de Fourier usuelle sont des fonctions sinusoïdales. Les fonctions sinusoïdales dépendent d'un unique paramètre : la fréquence. Dans le cas de l'analyse en ondelettes, les fonctions élémentaires font intervenir deux paramètres « a » et « b », où « a » est lié à la fréquence et « b » au temps.

Dans les expressions mathématiques qui suivent, les coefficients $C_{a,b}$ ([Math. 7]) correspondent à chaque fonction élémentaire $\Psi_{a,b}$ ([Math. 9]) utilisée pour décomposer un signal quelconque. Les coefficients $C_{a,b}$, sont représentatifs de propriétés temporelles et fréquentielles du signal. Les coefficients sont calculés en faisant la somme en continu du produit $P_{A\_def}(t)$ par la famille de fonctions élémentaires $\Psi_{a,b}(t)$. La famille d'ondelettes $\Psi_{a,b}$ est générée à partir d'une seule ondelette $\Psi$ appelée ondelette mère ou analysante ([Math. 8]). Les $\Psi_{a,b}$ sont construites par une translation dans le temps et par dilatation ou contraction dans le temps de $\Psi_{a,b}$.

[Math.7]

$$C_{a,b} = \int_{-\infty}^{+\infty} P_{A\_def}(t).\psi_{a,b}(t).dt$$

[Math.8]

$$\psi(t) = cos(5t).e^{-\frac{t^2}{2}}$$

(Ondelette mère de Morlet)

[Math.9]

$$\psi_{a,b}(t) = \frac{1}{\sqrt{a}}.\psi\left(\frac{t-b}{a}\right)$$

L'identification de la fréquence d'intérêt dans les coefficients $C_{a,b}$ se fait en calculant la valeur du paramètre « a », aussi appelé « paramètre d'intérêt », dans [Math. 10]. La représentation dans le temps du paramètre d'intérêt « a » est faite en prenant l'ensemble des valeurs de « b ». Le paramètre d'intérêt « a » dépend de l'ondelette mère utilisée pour l'analyse en ondelette, en particulier de sa fréquence centrale. La fréquence centrale de l'ondelette mère de Morlet est égale à 0,8125.

[Math.10]

$$a = \frac{0.8125}{f_{int}{}^*\Delta t}$$

Où $\Delta t$ est le pas de temps des mesures et $f_{int}$ la fréquence d'intérêt.

L'analyse en ondelettes de la puissance électrique statorique commence par le calcul du paramètre d'intérêt « a » en fonction des fréquences de défauts recherchés ([Math. 10]). Les résultats calculés par l'analyse en ondelette dépendent du temps et de ce paramètre d'intérêt « a ». Ainsi, pour chaque fréquence de défaut ($f_{def}(t)$ obtenue à l'opération 103) la valeur absolue du résultat de l'analyse est une courbe qui varie en fonction du temps. Le coefficient de défaut (« $Coef_{def}$ ») recherché pour une fréquence de défaut donnée est calculé en prenant le maximum du carré de la courbe sur toute la durée du signal et en le divisant par la puissance nominale de la génératrice ($P_n$) afin de le rendre adimensionnelle, comme exprimé dans [Math. 11] ci-après.

[Math.11]

$$Coef_{def} = \frac{max\left(\left|a(f_{def})\right|^2\right)}{P_n}$$

Enfin, dans l'opération 106, la représentation harmonique obtenue est comparée à une représentation harmonique de référence. À partir d'une ou plusieurs représentations harmoniques de référence de machine(s) avec défaut, un coefficient de défaut théorique, formant seuil, est prédéterminé. Le coefficient de défaut obtenu pour la machine surveillé est ensuite comparé à ladite valeur seuil prédéterminée.

De préférence, la représentation harmonique de référence est sélectionnée non seulement en fonction de la vitesse de rotation, mais aussi en fonction, en outre, d'une puissance réactive de la MADA et d'une tension statorique. En effet, la représentation harmonique de la puissance statorique (surtout les fréquences liées aux défauts) dépend aussi de la puissance réactive et de la tension statorique. Prendre en compte ces éléments est donc particulièrement avantageux : les risques d'erreur de détection sont réduits. Dans le cas contraire, possibilité des fausses alarmes et/ou des absences de détection de défaut peuvent se produire, réduisant la fiabilité de la surveillance.

Pour déterminer les seuils, des génératrices de type MADA saines et en défauts peuvent, par exemple, être modélisées au moyen de modèles par éléments finis et/ou de modèles de type circuit (basés sur des circuits équivalents). Les modèles par éléments finis permettent de modéliser finement les défauts de type court-circuit entre spires, tandis que les modèles circuits sont plus rapides et moins couteux en temps de calculs. Des essais en situations réelle sur des machines saines et d'autres ayant des défauts connus permettent, aussi, de déterminer des seuils en fonction de chaque type de MADA.

Dans l'exemple représenté en [Fig. 1], le procédé décrit ci-avant est itératif. Après une temporisation, le procédé est réinitialisé avec de nouvelles mesures. Autrement dit, le procédé peut être mis en œuvresensiblement de manière continue de sorte qu'une surveillance en temps réel est mise en œuvre.

[fig.4] et [Fig. 5] montrent des exemples de résultats (représentations fréquentielles) obtenues pour un même modèle de MADA de puissance nominale de 2 MW, respectivement sans défaut ([Fig. 4]) et avec un défaut de bobinage rotorique ([Fig. 5]), pour une vitesse de rotation de 1680 tr/min et une fréquence de défaut de 12 Hz. Les transformées en ondelettes permettent d'analyser un signal temporel d'une ou plusieurs périodes électriques pour le transformer en une représentation fréquentielle. La représentation fréquentielle, ou en harmoniques, est préférée car elle permet de s'affranchir de l'origine des temps et permet une meilleure classification du défaut dont la signature est représentée par une ou plusieurs raies de fréquences. Quant aux amplitudes de ces raies, elles sont utilisées comme paramètres de détection de défauts et comparées aux seuils de défauts dans les génératrices.

D'après les essais réalisés par la demanderesse, de nombreux types de défauts peuvent être détectés grâce à de tels procédés, et notamment des défauts électriques des bobinages au stator et/ou au rotor, des courts-circuits, des défauts de l'alimentation électrique au rotor, des défauts de charbon et de contact électrique glissant (ou « slip ring »), des défauts mécaniques comme les excentricités et des défauts de roulement.

L'invention a été décrite ci-avant sous la forme d'un procédé. Le procédé peut être mis en œuvre par des moyens informatiques. Aussi, l'invention peut prendre la forme d'une MADA équipée de capteurs de tension, de courant et de vitesse de rotation. Lesdits capteurs sont reliés à un module de calcul incluant au moins un processeur agencé de manière à mettre en œuvre, au moins en partie, le procédé décrit ci-avant. Le module de calcul peut être installé sur la MADA et être considéré comme un composant de cette dernière, ou bien être déporté. De même, un unique module de calcul peut recevoir des données de mesure d'une pluralité de MADA, de sorte que les calculs et la surveillance sont mis en œuvre de manière centralisée, par exemple pour la surveillance de tout ou partie d'un parc éolien. L'invention peut donc prendre la forme d'un système de surveillance comprenant au moins un module de calcul et les capteurs correspondants.

### Application industrielle

L'invention peut trouver à s'appliquer notamment dans le domaine de l'éolien terrestre ou maritime utilisant des génératrices de type MADA, sans pour autant s'y limiter.

L'invention ne se limite pas aux exemples de procédés, systèmes, programmes informatiques et supports d'enregistrement décrits ci-avant, seulement à titre d'exemple, mais elle englobe toutes les variantes que pourra envisager l'homme de l'art dans le cadre des revendications annexées.

### Revendications

1. Procédé de surveillance et détection de défaut dans une machine asynchrone à double alimentation incluant un stator et un rotor, ledit procédé étant mis en œuvre par des moyens informatiques, ledit procédé comprenant :

   a. recevoir (101), en entrée et en fonction du temps, une mesure de courant (I(t)) et une mesure de tension (U(t)) d'au moins une phase du stator, et une mesure de vitesse de rotation (v(t)) relative entre le stator et le rotor ;
   b. déduire (102) des mesures de courant (I(t)) et de tension (U(t)) reçues une puissance statorique (P(t)) en fonction du temps ;
   c. effectuer (105) une analyse harmonique de la puissance statorique (P(t)) obtenue, ladite analyse harmonique incluant d'appliquer une transformée en ondelettes à la puissance statorique (P(t)) obtenue, de sorte qu'une représentation (P(t,f)) harmonique de la puissance statorique, en fonction de la fréquence, est obtenue ;
   d. comparer (106) la représentation harmonique obtenue à une représentation harmonique de référence, ladite représentation harmonique de référence étant sélectionnée en fonction de la mesure de vitesse de rotation (v(t)), de manière à détecter des défauts dans ladite machine en fonction d'éventuelles différences identifiées par la comparaison.

2. Procédé selon la revendication précédente, dans lequel la représentation harmonique de référence est sélectionnée en fonction, en outre, d'une puissance réactive de la machine et d'une tension statorique.

3. Procédé selon l'une des revendications précédentes, dans lequel les mesures sont effectuées sur des durées comprises 1 et 5 secondes et/ou avec une fréquence d'échantillonnage comprise entre 5 et 20 kilohertz.

4. Procédé selon l'une des revendications précédentes, comprenant en outre, préalablement à l'analyse harmonique de la puissance statorique, une opération de détermination (103) d'au moins une fréquence ($f_{def}$(t)) d'un défaut connu en fonction de la vitesse de rotation v(t), l'analyse harmonique étant ensuite mise en œuvre pour chacune des fréquences de défaut ($f_{def}$(t)) déterminées.

5. Procédé selon l'une des revendications précédentes, comprenant en outre, après déduction (102) de la puissance statorique et préalablement à l'analyse harmonique de la puissance statorique, une opération de vérification (104) de stabilité des puissances au cours de la durée de prise de mesure.

6. Procédé selon l'une des revendications précédentes, dans lequel le procédé est répété de sorte qu'une surveillance en temps réel de la machine asynchrone à double alimentation est menée.

7. Système de surveillance d'au moins une machine asynchrone à double alimentation comprenant au moins un capteur de tension, un capteur de courant, un capteur de vitesse de rotation et un module de calcul, chaque capteur étant agencé pour transmettre des données de mesure à l'au moins un module de calcul, ledit module de calcul étant agencé pour mettre en œuvre un procédé selon l'une des revendications précédentes.

8. Programme informatique comportant des instructions qui conduisent le système de la revendication 7 à exécuter les étapes du procédé selon l'une des revendications 1 à 6.

9. Support d'enregistrement non transitoire lisible par un ordinateur sur lequel est enregistré le programme informatique selon la revendication 8.

**Patentansprüche**

1. Verfahren zur Überwachung und Detektion einer Störung in einer doppelt gespeisten Asynchronmaschine, die einen Stator und einen Rotor umfasst, wobei das Verfahren durch Rechnermittel umgesetzt wird, wobei das Verfahren Folgendes beinhaltet:

a. Empfangen (101), am Eingang und in Abhängigkeit von der Zeit, einer Strommessung (I(t)) und einer Spannungsmessung (U(t)) mindestens einer Phase des Stators und einer Messung der relativen Drehzahl (v(t)) zwischen dem Stator und dem Rotor;
b. Ableiten (102), aus den empfangenen Messungen des Stroms (I(t)) und der Spannung (U(t)), einer Statorleistung (P(t)) in Abhängigkeit von der Zeit;
c. Durchführen (105) einer Oberschwingungsanalyse der erhaltenen Statorleistung (P(t)), wobei die Oberschwingungsanalyse das Anwenden einer Wavelet-Transformation auf die erhaltene Statorleistung (P(t)) umfasst, sodass eine Oberschwingungsdarstellung (P(t,f)) der Statorleistung in Abhängigkeit von der Frequenz erhalten wird;
d. Vergleichen (106) der erhaltenen Oberschwingungsdarstellung mit einer Referenzoberschwingungsdarstellung, wobei die Referenzoberschwingungsdarstellung in Abhängigkeit von der Messung der Drehzahl (v(t)) ausgewählt wird, um Störungen in der Maschine in Abhängigkeit von möglichen, durch den Vergleich identifizierten Unterschieden zu detektieren.

2. Verfahren nach dem vorhergehenden Anspruch, wobei die Referenzoberschwingungsdarstellung ferner in Abhängigkeit von einer Blindleistung der Maschine und einer Statorspannung ausgewählt wird.

3. Verfahren nach einem der vorhergehenden Ansprüche, wobei die Messungen über Zeiträume zwischen 1 und 5 Sekunden und/oder mit einer Abtastfrequenz zwischen 5 und 20 Kilohertz durchgeführt werden.

4. Verfahren nach einem der vorhergehenden Ansprüche, das ferner vor der Oberschwingungsanalyse der Statorleistung einen Vorgang der Bestimmung (103) mindestens einer Frequenz ($f_{def}$(t)) einer bekannten Störung in Abhängigkeit von der Drehzahl v(t) beinhaltet, wobei die Oberschwingungsanalyse anschließend für jede der bestimmten Störungsfrequenzen (($f_{def}$(t)) umgesetzt wird.

5. Verfahren nach einem der vorhergehenden Ansprüche, das ferner nach der Ableitung (102) der Statorleistung und vor der Oberschwingungsanalyse der Statorleistung einen Vorgang der Überprüfung (104) der Stabilität der Leistungen während des Messzeitraums beinhaltet.

6. Verfahren nach einem der vorhergehenden Ansprüche, wobei das Verfahren wiederholt wird, sodass eine Überwachung der doppelt gespeisten Asynchronmaschine in Echtzeit vorgenommen wird.

7. System zur Überwachung mindestens einer doppelt gespeisten Asynchronmaschine, das mindestens einen Spannungssensor, einen Stromsensor, einen Drehzahlsensor und ein Berechnungsmodul beinhaltet, wobei jeder Sensor dazu angeordnet ist, Messdaten an das mindestens eine Berechnungsmodul zu übertragen, wobei das Berechnungsmodul dazu angeordnet ist, ein Verfahren nach einem der vorhergehenden Ansprüche umzusetzen.

8. Rechnerprogramm, das Anweisungen umfasst, die bewirken, dass das System nach Anspruch 7 die Schritte des Verfahrens nach einem der Ansprüche 1 bis 6 ausführt.

9. Computerlesbares, nichttransitorisches Aufzeichnungsmedium, auf dem das Rechnerprogramm nach Anspruch 8 aufgezeichnet ist.

**Claims**

1. A method for monitoring and detecting defects in a doubly-fed asynchronous machine including a stator and a rotor, said method being implemented by computer means, where said method comprises:

   a. receiving (101), as input and as a function of time, a current measurement (I(t)) and a voltage measurement (U(t)) of at least one phase of the stator, and a measurement of relative rotation speed (v(t)) between the stator and the rotor;
   b. deducing (102) a stator power (P(t)) as a function of time from received current (I(t)) and voltage (U(t)) measurements;
   c. performing (105) a harmonic analysis on the resulting stator power (P(t)), where said harmonic analysis includes applying a wavelet transform to the resulting stator power (P(t)), such that a harmonic representation (P(t,f)) of the stator power as a function of frequency results;
   d. comparing (106) the resulting harmonic representation to a reference harmonic representation, where said reference harmonic representation is selected as a function of the rotation speed (v(t)) measurement, so as to detect possible defects in said machine as a function of possible differences identified by the comparison.

2. The method according to the preceding claim wherein the reference harmonic representation is selected depending, further, on the reactive power of the machine and a stator voltage.

3. The method according to the preceding claim wherein the measurements are made for lengths included between 1 and 5 seconds and/or with a sampling frequency included between 5 and 20 kHz.

4. The method according to one of the preceding claims further comprising, prior to the harmonic analysis of the stator power, an operation of determining (103) at least one frequency ($f_{def}(t)$) of a known defect as a function of the rotation speed v(t), where the harmonic analysis is then implemented for each defect frequency ($f_{def}(t)$) determined.

5. The method according to one of the preceding claims further comprising, after deducing (102) the stator power and prior to harmonic analysis of the stator power, an operation of verifying stability (104) of the powers during the measurement time.

6. The method according to one of the preceding claims, wherein the method can be repeated such that real-time monitoring of the doubly-fed asynchronous machine is performed.

7. A system for monitoring at least one doubly-fed asynchronous machine is proposed comprising at least one voltage sensor, one current sensor, one rotation speed sensor and one calculation module, where each sensor is arranged for sending measurement data to the at least one calculation module and said calculation module is arranged for implementing a method according to one of the preceding claims.

8. A computer program comprising instructions that enables the system of claim 7 to execute the steps of the method according to one of claims 1 to 6.

9. A computer-readable nonvolatile recording medium on which is recorded the computer program of claim 8.

[Fig. 1]

**Fig. 1**

[Fig. 2]

**Fig. 2**

[Fig. 3]

Fig. 3

[Fig. 4]

Fig. 4

[Fig. 5]

# Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 106841900
- PL 220252

- CN 106597276